# EUROPEAN PATENT SPECIFICATION

(11) **EP 2 802 193 B1**
(45) Date of publication and mention of the grant of the patent: **03.08.2022**
(21) Application number: 14162600.2
(22) Date of filing: 31.03.2014
(51) Int. Cl.: H05K 3/00, G02B 6/44, H05K 3/10

(54) **Gas turbine engine**
Gasturbinentriebwerk
Moteur-turbine à gaz

(30) Priority: 03.05.2013 GB 201308030
(43) Date of publication of application: 12.11.2014
(73) Proprietor: Rolls-Royce plc, London N1 9FX (GB)
(72) Inventor: Broughton, Paul, Leicester, Leicestershire LE8 4EN (GB); Willmot, Michael, Sheffield, South Yorkshire S10 1UN (GB)
(74) Representative: Rolls-Royce plc

(56) References cited:
- GB-A- 1 260 339
- US-A1- 2005 257 956
- US-A1- 2008 185 478

## Description

The present invention relates to a gas turbine engine comprising an electrical harness.

A typical gas turbine engine has a substantial number of electrical components which serve, for example, to sense operating parameters of the engine and/or to control actuators which operate devices in the engine. Such devices may, for example, control fuel flow, variable vanes and air bleed valves. The actuators may themselves be electrically powered, although some may be pneumatically or hydraulically powered, but controlled by electrical signals.

Electrical power, and signals to and from the individual electrical components, is commonly transmitted along conductors. Conventionally, such conductors may be in the form of wires and/or cables which are assembled together in a harness. In such a conventional harness, each wire may be surrounded by an insulating sleeve, which may be braided or have a braided cover.

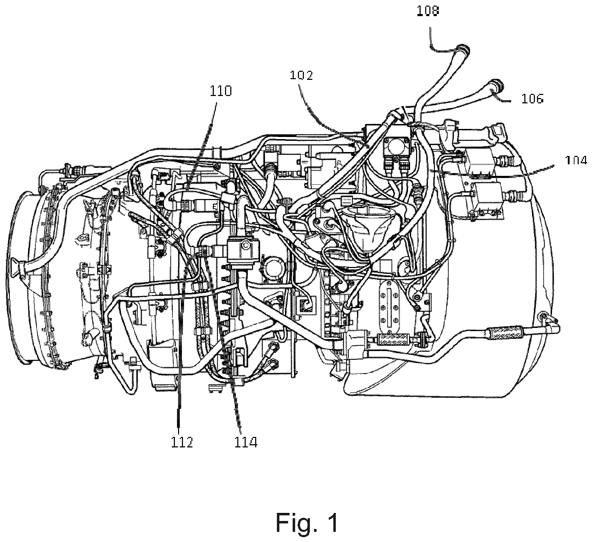

By way of example, Figure 1 of the accompanying drawings shows a typical gas turbine engine including two conventional wiring harnesses 102, 104, each provided with a respective connector component 106, 108 for connection to circuitry, which may be for example accommodated within the airframe of an aircraft in which the engine is installed. The harnesses 102, 104 are assembled from individual wires and cables which are held together over at least part of their lengths by suitable sleeving and/or braiding. Individual wires and cables, for example those indicated at 110, emerge from the sleeving or braiding to terminate at plug or socket connector components 112 for cooperation with complementary socket or plug connector components 114 on, or connected to, the respective electrical components.

Each conventional harness 102, 104 comprises a multitude of insulated wires and cables. This makes the conventional harness itself bulky, heavy and difficult to manipulate. The conventional harnesses occupy significant space within a gas turbine engine (for example within the nacelle of a gas turbine engine), and thus may compromise the design of the aircraft, for example the size and/or weight and/or shape of the nacelle.

Conventional harnesses comprise a large number of components, including various individual wires and/or bundles of wires, supporting components (such as brackets or cables) and electrical and/or mechanical connectors. This can make the assembly process complicated (and thus susceptible to errors) and/or time consuming. Disassembly of the conventional harnesses (for example removal of the conventional harnesses from a gas turbine engine during maintenance) may also be complicated and/or time consuming. Thus, in many maintenance (or repair or overhaul) procedures on a gas turbine engine, removal and subsequent refitting of the conventional electrical harness may account for a very significant portion of the operation time and/or account for a significant proportion of the potential assembly errors.

The electrical conductors in the conventional harnesses may be susceptible to mechanical damage. For example, mechanical damage may occur during installation (for example through accidental piercing of the protective sleeves/braiding) and/or during service (for example due to vibration). In order to reduce the likelihood of damage to the conductors in a conventional harness, the protective sleeves/braiding may need to be further reinforced, adding still further weight and reducing the ease with which they can be manipulated. Similarly, the exposed electrical connectors used to connect one conductor to another conductor or conductors to electrical units may be susceptible to damage and/or may add significant weight to the engine.

GB 1260339 A discloses a conduit comprising a rigid outer wall defining a closed interior which is divided by a rigid dividing member into at least two lengthwise extending spaces, one of which is adapted for the passage of pressure fluid and another of which is filled with magnesium oxide powder.

US 2009/0289232 A1 discloses a gas turbine having an electrical harness, wherein the conductors within the harness are a series of conductive paths formed from carbon nanotubes.

The present invention provides a gas turbine engine comprising an electrical harness as set out in the appended claims.

In a first aspect, the present invention provides a gas turbine engine comprising an electrical harness, wherein: at least a part of the electrical harness is formed by a rigid structure having an electrical system comprising electrical conductors embedded therein forming an electrical raft, the rigid structure further having one or more sensors embedded therein such that the electrical conductors and the sensors are surrounded, and thereby fixed in position, by the rigid material of the rigid structure; and the rigid structure is formed of rigid composite material; wherein the electrical conductors embedded in the electrical raft comprise electrically conductive tracks in a flexible printed circuit board and at least one electrically conductive wire which is individually surrounded by an electrically insulating sleeve.

The term rigid raft may be used herein to refer to the rigid structure having an embedded electrical system and/or conductors as described herein. A rigid raft may be referred to as an electrical raft.

Transferring electrical signals using the embedded electrical system of the rigid raft can provide a number of advantages over transferring electrical signals using a conventional harness. For example, during assembly and in use, such rafts may provide greater protection to their electrical conductors than conventional harnesses. Further, the use of such rafts may significantly reduce the build and maintenance times of an engine, and/or reduce the possibility of errors occurring during such procedures. The rafts can also provide weight and size advantages over conventional harnesses. Similar advantages accrue when fluids are transferred using the embedded fluid system of the rigid raft.

In addition, by embedding one or more sensors in the raft, it is possible to improve the monitoring of the raft. Further, the embedded sensors can be well-protected in the raft. The sensors can be embedded in the raft in the same way that the electrical conductors can be embedded therein, for example.

The electrical system may further comprise a flexible cable electrically connected between the rigid raft and another component of the electrical system.

Further optional features of the invention will now be set out. These are applicable singly or in any combination with any aspect of the invention.

The sensors may be temperature sensors (such as thermocouples, or resistance temperature detectors), fire sensors, vibration sensors (such as piezo-electric devices), strain gauges, and/or pressure sensors.

The raft may be formed of rigid composite material containing layers of continuous reinforcing fibres. In this case, the sensors may include one or more temperature sensor wires, the wires being sandwiched between neighbouring layers of continuous reinforcing fibres. The wires may extend in directions which make angles of at least 30° or at least 45° with the directions of extension of most (i.e. at least 50%), and preferably substantially all, of the reinforcing fibres in the neighbouring layers. Indeed, the wires may extend in directions which make angles of about 90° with the directions of extension of most, and preferably substantially all, of the reinforcing fibres in the neighbouring layers. In this way, the temperatures measured by the thermocouple wires may be less sensitive to preferential heat conduction along the lengths of the reinforcing fibres.

The sensors can be electrically connected with the electrical conductors. In this way, the electrical system can carry power to the sensors and/or it can carry signals to and/or from the sensors. That is, conveniently, power and/or signal cables for the sensors can be embedded in the raft.

The raft may further have a fluid system embedded therein.

In general, the use of one or more electrical rafts/electrical raft assemblies may significantly reduce build time of an engine. For example, use of electrical rafts/electrical raft assemblies may significantly reduce the part count involved in engine assembly compared with a conventional harness arrangement. The number and/or complexity of the operations required to assemble an engine (for example to assemble/install the electrical system (or network) and/or other peripheral components, which may be referred to in general as engine dressing) may be reduced. For example, rather than having to install/assemble a great number of wires and/or wiring looms together on the engine installation, it may only be necessary to attach a relatively small number of electrical rafts/electrical raft assemblies, which themselves may be straightforward to handle, position, secure and connect. Thus, use of electrical raft assemblies in a gas turbine installation may reduce assembly time and/or reduce the possibility of errors occurring during assembly.

Use of electrical raft assemblies may provide significant advantages during maintenance, such as repair and overhaul. As discussed above, the electrical rafts may be particularly quick and straightforward to assemble. The same advantages discussed above in relation to assembly apply to disassembly/removal from the gas turbine engine. Thus, any repair/overhaul that requires removal of at least a part of the electrical harness may be simplified and/or speeded up through use of electrical rafts as at least a part of the electrical harness, for example compared with conventional harnesses. Use of electrical rafts (for example as part of one or more electrical raft assemblies) may allow maintenance procedures to be advantageously adapted. For example, some maintenance procedures may only require access to a certain portion of the gas turbine engine that only requires a part of the harness to be removed. It may be difficult and/or time consuming, or not even possible, to only remove the required part of a conventional harness from a gas turbine engine. However, it may be relatively straightforward to only remove the relevant electrical raft, for example by simply disconnecting it from the engine and any other electrical rafts/components to which it is connected. Decreasing maintenance times has the advantage of, for example, reducing out-of service times (for example off-wing times for engines that are used on aircraft).

The build/assembly times may be additionally or alternatively reduced by pre-assembling and/or pre-testing individual and/or combinations of electrical rafts and/or electrical raft assemblies prior to engine assembly. This may allow the electrical and/or mechanical operation of the electrical rafts to be proven before installation, thereby reducing/eliminating the testing required during engine installation.

The electrical rafts/electrical raft assemblies may be a particularly lightweight solution for transferring electrical signals around an engine. For example, an electrical raft may be lighter, for example significantly lighter, than a conventional harness required to transmit a given number of electrical signals. A plurality of conductors may be embedded in a single electrical raft, whereas in a conventional arrangement a large number of heavy, bulky wires, usually with insulating sleeves, would be required. The reduced weight may be particularly advantageous, for example, when used on gas turbine engines on aircraft.

Electrical rafts may be more easily packaged and/or more compact, for example than conventional harnesses. Indeed, as mentioned above, the electrical rafts can be made into a very wide range of shapes as desired. This may be achieved, for example, by manufacturing the electrical rafts using a mould conforming to the desired shape. As such, each electrical raft may be shaped, for example, to turn through a tighter corner (or smaller bend radius) than a conventional harness. The electrical rafts may thus provide a particularly compact solution for transferring electrical signals around a gas turbine engine. The electrical rafts may be readily shaped to conform to neighbouring components/regions of a gas turbine engine, for example components/regions to which the particular electrical raft assembly is attached, such as a fan casing or a core casing.

The electrical raft(s) may provide improved protection to the electrical conductors during manufacture/assembly of the raft/gas turbine installation, and/or during service/operation/maintenance of the gas turbine engine. This may result in lower maintenance costs, for example due to fewer damaged components requiring replacement/repair and/or due to the possibility of extending time intervals (or service intervals) between inspecting the electrical system, for example compared with a system using only conventional harnesses.

Any suitable material may be used for the rigid material of the electrical raft. For example, the rigid material may be a rigid composite material, for example an organic matrix composite. Such a rigid composite material may be particularly stiff and/or lightweight. Thus, a rigid composite raft may be used that has suitable mechanical properties, whilst being thin and lightweight, for example compared with some other materials. The rigid composite material may comprise any suitable combination of resin and fibre as desired for a particular application. For example, any of the resins and/or fibres described herein may be used to produce a rigid composite material for the electrical raft. Any suitable fibres may be used, for example carbon fibres, glass fibres, aramid fibres, and/or para-aramid fibres. The fibres may be of any type, such as woven and/or chopped. Any suitable resin may be used, for example epoxy, BMI (bismaleimide), PEEK (polyetheretherketone), PTFE (polytetraflouroethylene), PAEK (polyaryletherketone), polyurethane, and/or polyamides (such as nylon).

At least some (for example a plurality) of the electrical conductors are provided in a flexible printed circuit (FPC). Thus, at least some of the electrical conductors are provided as electrically conductive tracks in a flexible substrate. The flexible printed circuit may be flexible before being embedded in the rigid material.

Providing the electrical conductors as tracks in a flexible printed circuit may allow the size of the resulting electrical raft to be reduced further and/or substantially minimized. For example, many different electrical conductors may be laid into a flexible printed circuit in close proximity, thereby providing a compact structure. The flexible substrate of a single flexible printed circuit may provide electrical and/or mechanical protection/isolation to a large number of electrical conductors.

Any given electrical raft may be provided with one or more electrical wires embedded therein (which may be sheathed) and/or one or more flexible printed circuits embedded therein. As such, a given electrical raft may have wires and flexible printed circuits laid therein.

It will be appreciated that the embedded electrical conductors (whether they are provided as embedded electrical wires or as conductive tracks in a flexible printed circuit embedded in the rigid material) and/or sensors may be described as being fixed in position by the rigid material, for example relative to the rest of the raft. It will also be appreciated that the embedded electrical conductors and/or sensors may be said to be surrounded by the rigid material and/or buried in the rigid material and/or integral with (or integrated into) the rigid material.

An electrical raft (or electrical raft assembly) may comprise a fluid passage. Such a fluid passage may be embedded therein and/or otherwise provided thereto. The fluid passage may be part of a fluid system, such as a gas (for example pneumatic or cooling gas/air) and/or liquid (for example a fuel, hydraulic and/or lubricant liquid).

Thus, there is provided a gas turbine engine or gas turbine engine installation (for example for an airframe) comprising an electrical raft and/or an electrical raft assembly as described herein. For example, at least one electrical raft and/or electrical raft assembly may be used as part of an electrical harness for transferring electrical signals around the engine, in the form of electrical harness raft(s) and/or electrical harness raft assemblies.

The electrical raft may comprise one or more electrical connectors or sockets, which may be electrically connected to at least one of the embedded electrical conductors. The electrical connector or socket may allow electrical connection of the electrical raft to other electrical components, for example to other electrical rafts (either directly or indirectly, via an electrical cable or lead) or to electrical units (again, either directly or indirectly, via an electrical cable or lead). Such an electrical connector or socket may take any suitable form, and may be at least partially embedded in the rigid electrical raft.

The electrical raft assembly may be a first engine installation component, and the gas turbine engine may further comprise a second engine installation component having electrical conductors. The gas turbine engine may further comprise at least one flexible cable connected between the electrical raft assembly and the second engine installation component so as to electrically connect electrical conductors of the electrical raft assembly with electrical conductors of the second engine installation component.

The second engine installation component may be, for example, an ECU, such as an EMU or EEC. Additionally or alternatively, the second engine installation component may be a further electrical raft or electrical raft assembly.

The environment of a gas turbine engine during operation may be particularly severe, with, for example, high levels of vibration and/or differential expansion between components as the temperature changes through operation and as the components move relative to each other. Providing at least one flexible cable to connect an electrical raft assembly to another component may allow the electrical rafts and/or components to accommodate vibration and/or relative movement, for example of the component(s)/assemblies to which they are attached/mounted during use. For example, the flexible cable(s) (where present) used to electrically connect electrical raft assemblies to other component(s) may have sufficient length to accommodate such vibration and/or movement during use.

For example, providing separate (for example more than one) electrical raft assemblies and connecting at least some (for example at least two) of them together using at least one flexible cable may allow the electrical rafts to accommodate vibration and/or relative movement of the component(s)/assemblies to which they are attached/mounted during use.

The electrical signals transferred by the conductors in the electrical raft, and around the engine using the electrical rafts/raft assemblies may take any form. For example, the electrical signals may include, by way of non-limitative example, electrical power and/or electrical control/communication signals and/or any other type of transmission through an electrical conductor. Transmission of signals around the engine may mean transmission of signals between (to and/or from) any number of components/systems in the engine and/or components/system of a structure (such as an airframe) to which the gas turbine engine is (or is configured to be) connected/installed in. In other words, an electrical raft may be used to transfer/communicate any possible combination of electrical signals in any part of a gas turbine engine.

An electrical raft or raft assembly may be provided in any suitable location/position of the gas turbine engine, for example to a mounting structure at any suitable location. For example, the gas turbine engine may comprise a bypass flow duct formed between an engine core and an engine fan casing (the gas turbine engine may be a turbofan engine, for example); and the electrical raft assembly may form at least a part of a radially extending splitter (which may be referred to as a bifurcation) that extends across the bypass flow duct. In this way, an electrical raft (which may be referred to as a splitter electrical raft) may provide an electrical connection between a fan casing and an engine core. By way of further example, the electrical raft assembly may be attached to the engine core case or engine fan case, for example to a mounting structure on such cases.

Other components/systems of a gas turbine engine may be provided to an electrical raft assembly in any suitable manner. For example, such other components/systems may be mounted on one or more electrical raft assemblies. Thus, a surface of an electrical harness raft may be used as a mounting surface for other gas turbine engine components/systems, such as ancillary/auxiliary components/systems.

For example, an electrical unit may be mounted on an electrical raft. The electrical unit may be any sort of electrical unit, for example one that may be provided to a gas turbine engine. For example, the electrical unit may be any type of electronic control unit (ECU), such as an Electronic Engine Controller (EEC) and an Engine Health Monitoring Unit (EMU). At least one (i.e. one or more) electrical unit may be attached to an electrical raft. Such an electrical raft assembly may be a particularly convenient, lightweight and/or compact way of providing (for example attaching, fixing or mounting) an electrical unit to a turbine engine. For example, the electrical unit and the electrical raft may be assembled together (mechanically and/or electrically) before being installed on the gas turbine engine, as described elsewhere herein.

An electrical raft may be provided with at least one mount on which other components (for example auxiliary/ancillary components/systems) of the gas turbine engine are (or may be) mounted. The mount may be a bracket, for example a bespoke bracket for the component/system mounted thereon or a conventional/standard bracket. The electrical raft may provide a stable, regular and convenient platform on which to mount the various systems/components. The combination of the installed electrical raft assembly with components/systems mounted thereon may be much more compact and/or straightforward to assemble and/or have a greatly reduced number of component parts, for example compared with the corresponding conventional electrical harness and separately mounted components/systems.

The mounts may be used to attach any component/system to an electrical raft (and thus to the engine) as required. For example, fluid pipes for transferring fluid around the engine may be mounted to the electrical rafts (for example mechanically mounted using a bracket), and thus to the engine. More than one set of fluid pipes, for example for carrying different or the same fluids, may be mounted on the same electrical raft.

An anti-vibration mount may be used to attach an electrical raft to another component, thereby allowing the electrical raft to be vibration isolated (or at least substantially vibration isolated). Using an anti-vibration mount to attach an electrical raft/assembly to a gas turbine engine for example may reduce (or substantially eliminate) the amount (for example the amplitude and/or the number/range of frequencies) of vibration being passed to the electrical raft from the gas turbine engine, for example during use. This may help to prolong the life of the electrical raft. Furthermore, any other components that may be attached to the electrical raft (as discussed above and elsewhere herein) may also benefit from being mounted to the gas turbine engine via the anti-vibration mounts, through being mounted on the electrical raft. For example, the reduced vibration may help to preserve the electrical contact between the electrical raft and any electrical unit connected thereto. As such, any components (such as an electrical unit mounted to the electrical raft) that would conventionally be mounted directly to the gas turbine engine and require at least a degree of vibration isolation no longer require their own dedicated anti-vibration mount. Thus, the total number of anti-vibration mounts that are required to assemble an engine may be reduced. This may reduce the number of parts required and/or the time taken to assemble an engine or engine installation and/or reduce the total assembled weight and/or reduce the likelihood of errors occurring during assembly.

Furthermore, components that are conventionally mounted to an engine without anti-vibration mounts (for example because of the weight and/or cost penalty), but which are now mounted to an electrical raft (for example to a mounting surface of the electrical raft), may benefit from vibration isolation without any weight/cost/assembly time penalty. This may reduce the possibility of damage occurring to such components and/or increase their service life. Such components may include, for example, ignitor boxes (used to provide high voltage power to engine ignitors), and pressure sensors/switches, for example for fluid systems such as oil, air, fuel, pneumatics and/or hydraulics.

Further optional features of the invention are set out below.

Embodiments of the invention will now be described by way of example with reference to the accompanying drawings in which:
Figure 1 shows a gas turbine engine with a conventional harness;
Figure 2 shows a cross-section through a gas turbine engine in accordance with the present invention;
Figure 3 shows a perspective view of a flexible printed circuit;
Figure 4 shows a side view of the flexible printed circuit of Figure 3;
Figure 5 shows a schematic of an electrical raft prior to assembly;
Figure 6 shows a cross-section normal to the axial direction through a gas turbine engine in accordance with the present invention;
Figure 7 shows schematically a cross-sectional view of a rigid electrical composite raft containing embedded sensors;
Figure 8 shows schematically resin transfer moulding of a raft containing an embedded sensor;
Figure 9 shows schematically autoclaving of a raft containing an embedded sensor; and
Figure 10 shows schematic examples (a) and (b) of how the profile of an autoclaved raft surface may change due to the presence of an embedded sensor.

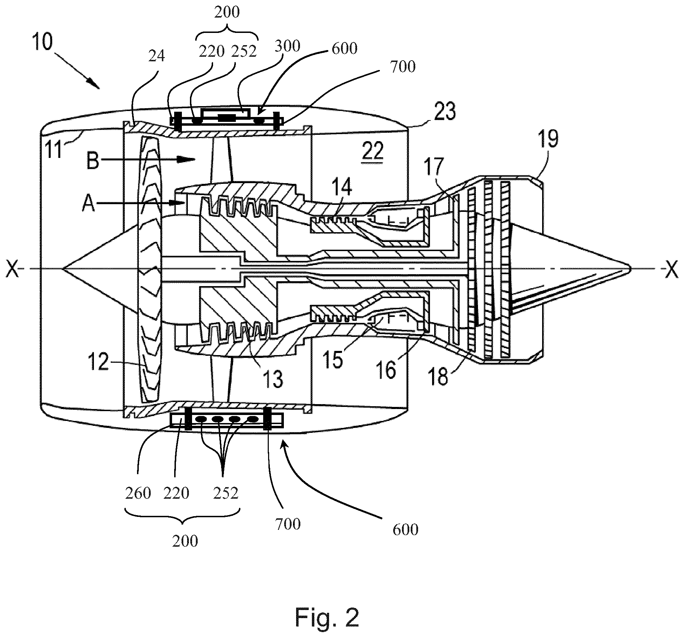

With reference to Figure 2, a ducted fan gas turbine engine generally indicated at 10 has a principal and rotational axis X-X. The engine 10 comprises, in axial flow series, an air intake 11, a propulsive fan 12, an intermediate pressure compressor 13, a high-pressure compressor 14, combustion equipment 15, a high-pressure turbine 16, and intermediate pressure turbine 17, a low-pressure turbine 18 and a core engine exhaust nozzle 19. The engine also has a bypass duct 22 and a bypass exhaust nozzle 23.

The gas turbine engine 10 works in a conventional manner so that air entering the intake 11 is accelerated by the fan 12 to produce two air flows: a first air flow A into the intermediate pressure compressor 13 and a second air flow B which passes through the bypass duct 22 to provide propulsive thrust. The intermediate pressure compressor 13 compresses the air flow A directed into it before delivering that air to the high pressure compressor 14 where further compression takes place.

The compressed air exhausted from the high-pressure compressor 14 is directed into the combustion equipment 15 where it is mixed with fuel and the mixture combusted. The resultant hot combustion products then expand through, and thereby drive the high, intermediate and low-pressure turbines 16, 17, 18 before being exhausted through the nozzle 19 to provide additional propulsive thrust. The high, intermediate and low-pressure turbines 16, 17, 18 respectively drive the high and intermediate pressure compressors 14, 13 and the fan 12 by suitable interconnecting shafts.

The gas turbine engine 10 shown in Figure 2 shows two electrical raft assemblies 600.

The gas turbine engine 10 is in accordance with the present invention. Each electrical raft assembly 600 comprises an electrical raft 200. The electrical rafts 200 may be used to transmit/transfer electrical signals (or electricity, including electrical power and/or electrical control signals) around the engine and/or to/from the engine 10 from other components, such as components of an airframe. The function and/or construction of each electrical raft 200 and electrical raft assembly 600 may be as described above and elsewhere herein.

In Figure 2, each electrical raft 200 (which may be referred to herein simply as a raft 200 or an electrical harness raft 200) comprises at least one electrical conductor 252 embedded in a rigid material 220, which is a rigid composite material.

The electrical conductors 252 in the electrical raft 200 are provided in a harness 250, which is a flexible printed circuit board (or FPC) 250.

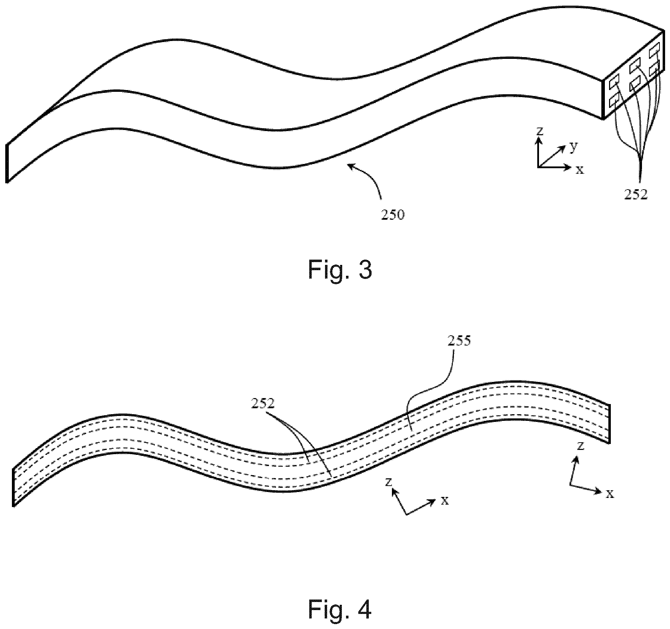

An example of an FPC 250 in which the electrical conductors 252 may be provided is shown in greater detail in Figures 3 and 4. Figure 3 shows a perspective view of the FPC 250, and Figure 4 shows a side view.

Such an FPC 250 comprises a flexible (for example elastically deformable) substrate 255 with conductive tracks 252 laid/formed therein. The FPC 250 may thus be deformable. The FPC 250 may be described as a thin, elongate member and/or as a sheet-like member. Such a thin, elongate member may have a major surface defined by a length and a width, and a thickness normal to the major surface. In the example shown in Figures 3 and 4, the FPC 250 may extend along a length in the x-direction, a width in the y-direction, and a thickness (or depth or height) in the z-direction. The x-direction may be defined as the axial direction of the FPC. Thus, the x-direction (and thus the z-direction) may change along the length of the FPC 250 as the FPC is deformed. This is illustrated in Figure 4. The x-y surface(s) (i.e. the surfaces formed by the x and y directions) may be said to be the major surface(s) of the FPC 250. In the example shown in Figures 3 and 3, the FPC 250 is deformable at least in the z direction, i.e. in a direction perpendicular to the major surface. FPCs may be additionally of alternatively deformable about any other direction, and/or may be twisted about any one or more of the x, y, or z directions.

The flexible substrate 255 may be a dielectric. The substrate material may be, by way of example only, polyamide. As will be readily apparent, other suitable substrate material could alternatively be used.

The conductive tracks 252, surrounded by the substrate 255, may be formed using any suitable conductive material, such as, by way of example only, copper, copper alloy, tin-plated copper (or tin-plated copper alloy), silver-plated copper (or silver-plated copper alloy), nickel-plated copper (or nickel-plated copper alloy) although other materials could alternatively be used. The conductive tracks 252 may be used to conduct/transfer electrical signals (including electrical power and electrical control signals) through the rigid raft assembly (or assemblies) 200, for example around a gas turbine engine 10 and/or to/from components of a gas turbine engine and/or an airframe attached to a gas turbine engine.

The size (for example the cross-sectional area) and/or the shape of the conductive tracks 252 may depend on the signal(s) to be transmitted through the particular conductive track 252. Thus, the shape and/or size of the individual conductive tracks 252 may or may not be uniform in a FPC 250.

The example shown in Figures 3 and 4 has six conductive tracks 252 running through the substrate 255. However, the number of conductive tracks 252 running through a substrate 255 could be fewer than six, or greater than six, for example tens or hundreds of tracks, as required. As such, many electrical signals and/or power transmission lines may be incorporated into a single FPC 250.

A single FPC 250 may comprise one layer of tracks, or more than one layer of tracks, for example, 2, 3, 4, 5, 6, 7, 8, 9, 10 or more than 10 layers of tracks. An FPC may comprise significantly more than 10 layers of tracks, for example at least an order of magnitude more layers of tracks. In this regard, a layer of tracks may be defined as being a series of tracks that extend in the same x-y surface. Thus, the example shown in Figures 3 and 4 comprises 2 layers of tracks, with each layer comprising 3 tracks 252.

An electrical raft 200 may be manufactured using any suitable method, shown as an example not forming a part of the invention and only presented in order to provide better understanding of the invention. For example, the rigid material 220 may initially be provided as layers of flexible material, such as (by way of example only) layers of fibre and resin compound. This flexible material may be placed into a mould, for example having a desired shape. Other components (such as fluid pipes 210 and/or the electrical conductors 252, which may be embedded in a FPC 250) may also be placed into the mould, for example between layers of the flexible material from which the rigid material 220 is ultimately formed. Parts of the mould may have any suitable form and/or construction, for example that could be readily removed when the electrical raft 200 is formed into the desired shape.

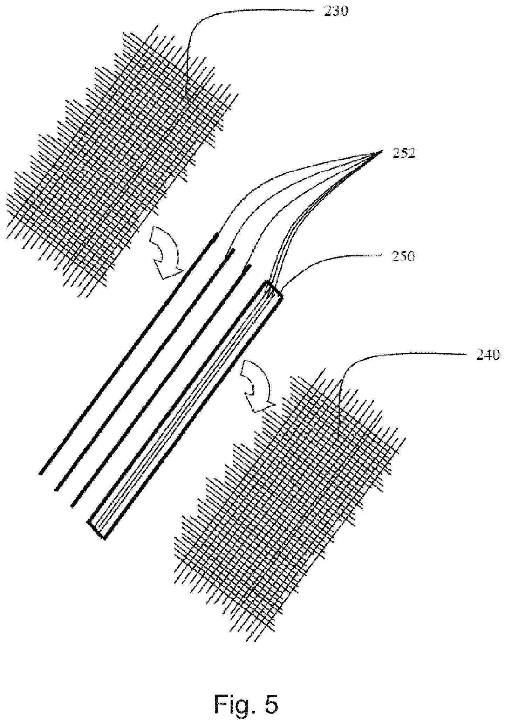

Figure 5 shows components of an example of an electrical raft 200 prior to one method of construction. The electrical conductors 252 are provided between two layers of material 230, 240 that, after construction, form the rigid material 220. Some of the electrical conductors 252 are provided in an FPC 250. The material 230, 240 may be a fibre and resin compound, as described elsewhere herein. Such a fibre and resin compound may, after suitable treatment (for example heat treatment), produce the rigid composite material 220.

In the example of Figure 5, the fibre and resin compound is formed of a sheet of interwoven fibres, or strands. The strands in Figure 5 extend in perpendicular directions, although the strands may extend in any one or more directions as required. The strands/fibres may be pre-impregnated (or "pre-pregged") with the resin.

Prior to any treatment, both the first and second layers 230, 240 and the electrical conductors 252 may be flexible, for example supple, pliable or malleable. As such, when the layers 230, 240 and the electrical conductors 252 are placed together, they may be moulded, or formed, into any desired shape. For example, the layers 230, 240 and the electrical conductors 252 may be placed into a mould (which may be of any suitable form, such as a glass or an aluminium mould) having the desired shape. The desired shape may be, for example, a shape that corresponds to (for example is offset from) a part of a gas turbine engine, such as, by way of example only, at least a part of a casing, such as an engine fan casing or engine core casing. This may enable the final raft to adopt shapes that are curved in two-dimensions or three-dimensions.

Any suitable method not forming a part of the invention could be used to produce the electrical raft 200. For example, the strands/fibres need not be pre-impregnated with the resin. Instead, the fibres/strands could be put into position (for example relative to electrical conductors 252/FPC 250) in a dry state, and then the resin could be fed (or pumped) into the mould. Such a process may be referred to as a resin transfer method. In some constructions no fibre may be used at all in the rigid material 220.

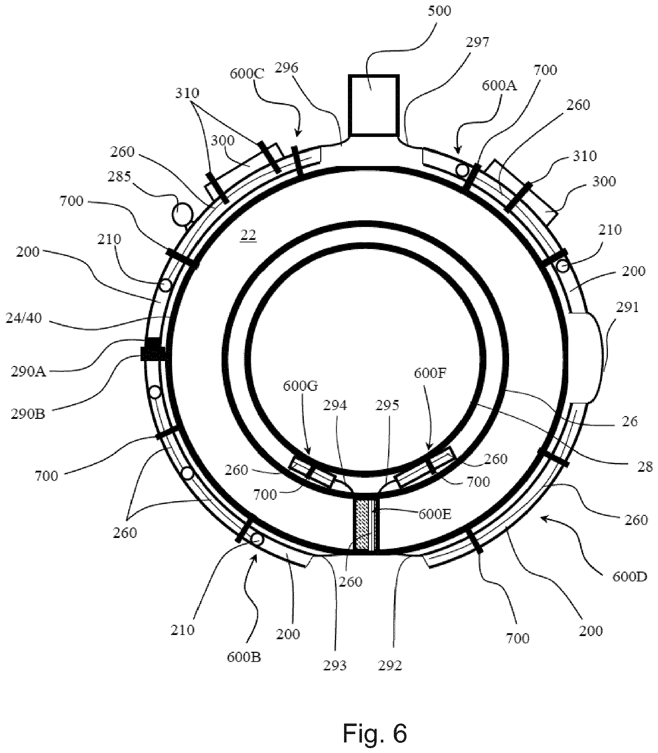

Figure 6 is a schematic showing a cross-section perpendicular to the direction X-X of a gas turbine engine comprising electrical raft assemblies 600A-600G. Any one of the electrical raft assmblies 600A-600G may comprise any or all of the features of an electrical raft assembly 600 as described above, for example. Thus, for example, any one of the electrical raft assemblies may comprise an electrical raft 200 (not labelled for raft assemblies 600E-600G for simplicity only) having electrical conductors 252 and sensors (not labelled in Figure 6 for simplicity only) embedded therein. Some or all of the electrical raft assemblies 600A-600G (which may collectively be referred to as electrical raft assemblies 600) comprise a mounting fixture for attaching the respective assembly 600 to a mounting structure 700 (such as an anti-vibration mount).

The mounting structure is part of a fan case 24 for electrical raft assemblies 600A-600D, part of a bifurcation splitter that radially crosses a bypass duct 22 for electrical raft assemblies 600E and part of an engine core case 28 for electrical raft assemblies 600F and 600G. However, it will be appreciated that an electrical raft assembly 600 could be mounted in any suitable and/or desired location on a gas turbine engine.

In Figure 6, two electrical raft assemblies 600A, 600C are shown as having an electrical unit 300 mounted on the respective electrical raft 200. However, any (or none) of the electrical raft assemblies 600A-600G may have an electrical unit 300 mounted to the respective electrical raft 200.

As mentioned herein, each of the electrical rafts 200 associated with the electrical raft assemblies 600A-600G shown in Figure 6 comprises one or more electrical conductors 252 embedded therein. However, in an example not forming a part of the invention any one or more of the electrical rafts 200 may be replaced with a raft that does not comprise electrical conductors 252. Such a raft would not be an electrical raft 200, but may otherwise be as described elsewhere herein, for example it may be a rigid raft that may have components/systems (such as, by way of example only, fluid systems, such as pipes) mounted thereon and/or embedded therein. Thus, for example, a gas turbine engine in accordance with the present invention may have a combination of electrical rafts 200 and non-electrical rafts.

The arrangement of electrical raft assemblies 600A-600G shown in Figure 6 is by way of example only. Alternative arrangements, for example in terms of number, size, shape and/or positioning, of electrical raft assemblies 600A-600G may be used. For example, there need not be seven electrical raft assemblies, the assemblies may or may not be connected together, and the rafts could be provided to (for example mounted on) any one or more components of the gas turbine engine. Purely by way of example only, connection between electrical raft assemblies 600A-600D mounted on the fan casing 24 to the electrical raft assemblies 600F, 600G mounted on the core casing 28 may be provided at least in part by means other than an additional electrical raft assembly 600E, for example using wire conductors with insulating sleeves. By way of further example, one or more electrical raft assemblies 600 may additionally or alternatively be provided to the nose cone, structural frames or elements within the engine (such as "A-frames"), the nacelle, the fan cowl doors, and/or any connector or mount between the gas turbine engine 10 and a connected structure (which may be at least a part of a structure in which the gas turbine engine 10 is installed), such as the pylon 500 between the gas turbine engine 10 and an airframe (not shown).

Any one or more of the electrical rafts of the electrical raft assemblies 600A-600G may have a fluid passage 210 embedded therein and/or provided thereto. The fluid passage 210 may be part of a fluid system, such as a gas (for example pneumatic or cooling gas/air) and/or liquid (for example a fuel, hydraulic and/or lubricant liquid). In the Figure 6 example, three of the electrical rafts (of electrical raft assemblies 600A, 600B, 600C) comprise a fluid passage 210 at least partially embedded therein. The electrical raft of assembly 600C also has a fluid passage 285 (which may be for any fluid, such as those listed above in relation to embedded passage 210) mounted thereon. Such a mounted fluid passage 285 may be provided to any electrical raft, such as those of electrical raft assemblies 600A-600G shown in Figure 6. The fluid passages 210, 285 shown in Figure 6 may be oriented in an axial direction of the engine 10. However, fluid passages may be oriented in any direction, for example axial, radial, circumferential or a combination thereof.

Any of the electrical raft assemblies 600A-600G (or the respective electrical rafts 200 thereof) may have any combination of mechanical, electrical and/or fluid connections to one or more (for example 2, 3, 4, 5 or more than 5) other components/systems of the gas turbine engine 10 and/or the rest of the gas turbine engine 10. Examples of such connections are shown in Figure 6, and described below, but other connectors may be used. For example, electrical raft assemblies 600 (and/or non-electrical rafts) may be connected together (or to other components) using any combination of electrical, fluid and/or mechanical connectors. Thus, any of the connections 290A/290B, 291-297 shown in Figure 6 may be any combination of electrical, fluid and/or mechanical connection. Alternatively, electrical raft assemblies 600 (and/or non-electrical rafts) may be standalone, and thus may have no connection to other rafts or components.

A connection 291 is shown between the electrical rafts of the assemblies 600A and 600D.

The connection 291 may comprise an electrical connection. Such an electrical connection may be flexible and may, for example, take the form of a flexible printed circuit such as the flexible printed circuit 250 shown in Figures 3 and 4. Such a flexible electrical connection may be used to electrically connect any electrical raft assembly 600 to any other component, such as another electrical raft assembly 600. A connection 297 (which may be or comprise an electrical connection) is provided between the electrical raft of the assembly 600A and a part of an airframe, or airframe installation 500, which may, for example, be a pylon. Similarly, a fluid and/or mechanical connection 296 may additionally or alternatively be provided between the airframe 500 and another electrical raft of the assembly 600C. As shown in Figure 6, other electrical and/or fluid connections 292, 293, 294, 295 may be provided between electrical rafts 200 (or assemblies 600) and other components, such as other electrical rafts 200 (or assemblies 600).

A direct connection 290A, 290B may be provided, as shown for example between the electrical rafts of the assemblies 600B and 600C in the Figure 6 arrangement. Such a direct connection 290A, 290B may comprise a connector 290A provided on (for example embedded in) one electrical raft 200 connected to a complimentary connector 290B provided on (for example embedded in) another electrical raft 200. Such a direct connection 290A, 290B may, for example, provide fluid and/or electrical connection between the two electrical rafts assemblies 600B, 600C.

An electrical raft 200 may have an electrically conductive grounding or screen layer 260, as shown in the electrical rafts 200 shown in Figure 6. However, it will be appreciated that electrical rafts 200 for use with the invention need not have such an electrically conductive grounding or screen layer 260. Where an electrically conductive grounding or screen layer 260 is present, an electrically conductive fastener 310 may be used to fasten, or fix, the electrical unit 300 (where present) to the electrical raft 200. This may allow the electrical unit 300 to be electrically grounded. It will also be appreciated, however, that electrical rafts 200 according to the invention and/or for use with the invention need not have such an electrically conductive fastener 310.

Where reference is made herein to a gas turbine engine, it will be appreciated that this term may include any type of gas turbine engine, including, but not limited to, a turbofan (bypass) gas turbine engine, turbojet, turboprop, ramjet, scramjet or open rotor gas turbine engine, and for any application, for example aircraft, industrial, and marine application. Electrical raft assemblies 600 such as any of those described and/or claimed herein may be used as part of any apparatus, such as any vehicle, including land, sea, air and space vehicles, such as motor vehicles (including cars and busses), trains, boats, submarines, aircraft (including aeroplanes and helicopters) and spacecraft (including satellites and launch vehicles).

It will be appreciated that many alternative gas turbine engines 10 comprising electrical raft assemblies 600 other than those described herein may fall within the scope of the invention defined by the appended claims. For example, alternative arrangements of electrical raft assemblies 600 (for example in terms of the arrangement, including number/shape/positioning/constructions, of mounting fixtures, the arrangement/shape/positioning/construction of the electrical rafts 200, the type and/or positioning of components (if any) mounted to/embedded in the electrical rafts 200, the rigid composite material 220 and the electrical conductors 252) may fall within the scope of the invention and may be readily apparent to the skilled person from the disclosure provided herein.

Alternative arrangements of connections (for example mechanical, electrical and/or fluid) between the electrical (or non-electrical) rafts and/or raft assemblies and between the electrical (or non-electrical) rafts or raft assemblies and other components may fall within the scope of the invention as defined by the appended claims and may be readily apparent to the skilled person from the disclosure provided herein.

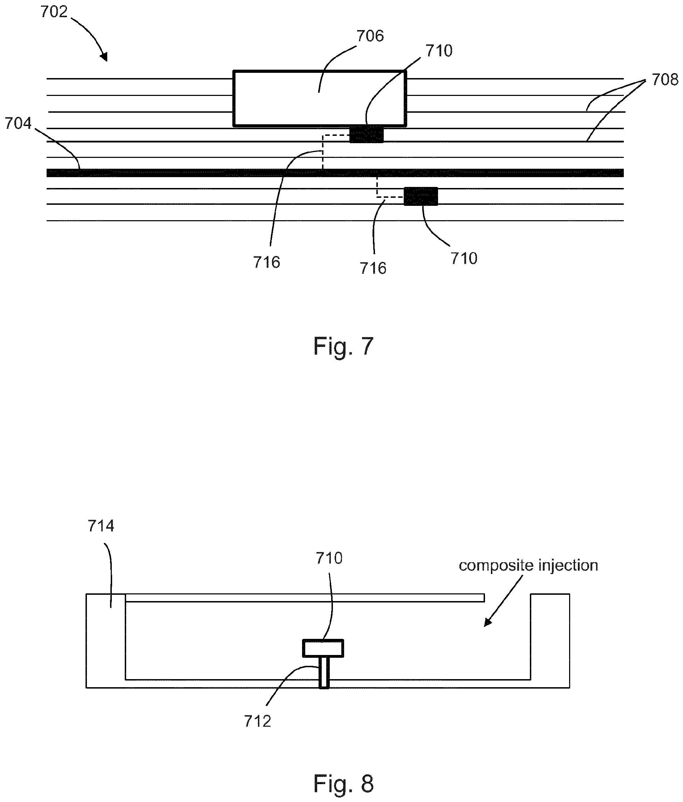

Figure 7 shows schematically a cross-sectional view of a rigid electrical composite raft 702.

The raft 702 may have the position, structure and features of any one of the rafts 200 or raft assemblies 600 described above in relation to Figures 2 to 6. The raft includes an electrical system comprising an FPC 704 embedded in the polymer matrix composite material of the raft. Electrical connectors and/or flexible cables (not shown) can connect the electrical conductors of the FPC to other components of the engine. For example, the raft may carry an electrical unit 706 such as an engine electronic control unit which is connected to the FPC. The unit can be embedded in the raft (as shown in Figure 7) or may be mounted to a surface thereof e.g. via anti-vibration mounts.

The composite material of the raft 702 can be formed from layers 708 of material, e.g. as described above in relation to Figure 5. For example, the layers can be consolidated by an autoclave method in which flexible layers of fibre reinforcement are placed on a hard mould tool and bonded together by curing of a resin applied between the layers. The resin can be applied separately and/or as part of pre-impregnated layers. However, another approach is to form the raft by composite material injection moulding.

Embedded within the raft 702 are a number of sensors 710. Although not shown in Figures 2 to 6, the rafts or raft assemblies illustrated therein have such embedded sensors. The sensors can be positioned in the raft at the same time that the raft is formed. For example, the sensors can be sandwiched between the flexible layers of fibre reinforcement during build-up of the raft before autoclaving, or can be held in a desired location by supports 712 in the mould 714 during resin transfer moulding (injection moulding), as show in Figure 8.

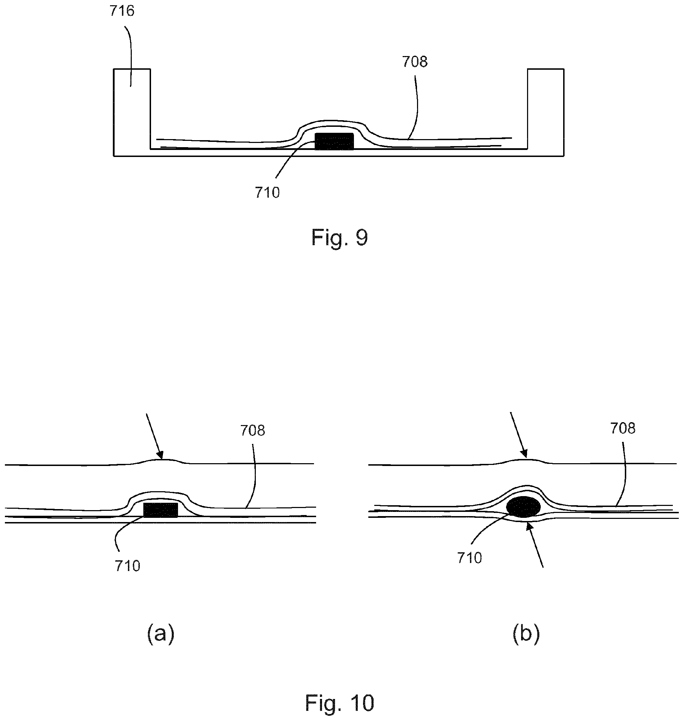

Figure 9 shows schematically an autoclaving procedure which does not form a part of the invention and is provided only for better understanding of the invention. in which layers of composite 708 are placed on a hard mould tool 716 around a sensor 710. The layers then bond together due to the curing of resin applied between the composite layers. As shown in Figures 10(a) and (b), the profile of the autoclaved raft surface may change slightly (arrowed) due to the presence of the sensor. However, generally only one surface of the raft has aerodynamic importance (usually it is the inner surface), and as shown in Figure 9(a), it is possible to arrange the moulding so that the profile is affected on only one surface.

The sensors 710 can be of various type, such as temperature sensors, fire sensors, vibration sensors, strain gauges, and/or pressure sensors. The sensors may be electrically connected to the electrical conductors of the FPC 704 (as indicated in Figure 7 by the dashed lines), which conveniently can carry power to the sensors and/or can carry signals to and/or from the sensors.

Temperature sensors, such as thermocouples and resistance temperature detectors, can be used to detect overheat and fire conditions. Thus they may be located in respective fire zones of the engine. They can also be used to detect local thermal effects before permanent damage and in-service incidents develop e.g. in relation to the raft or any components attached thereto.

Sensors in the form of embedded temperature sensors wires preferably extend in directions which are angled away (e.g. by 30° or more) from the directions of extension of most of the fibre reinforcement in the composite material. Since composite structures tend to transfer heat better along the directions of the fibres, excessive heat transfer to the thermocouple wires can thereby be avoided.

Fire sensors can be in the form of tubes containing a gas which expands on overheating to produce a detectable high pressure, or in the form of wires which have variable capacitance/inductance with temperature. Such tubes/wires can be run around the engine to detect the first appearance of fire as soon as possible.

Vibration sensors can be based on piezo-electric crystals, and may be used to detect mechanical damage to bearings, turbine/compressor blades etc.

Strain gauges can be based on thin serpentine wires (e.g. akin to printed circuit board wires), the electrical resistance of such wires changing in response to strain-induced stretching. Generally, individual strain gauges can be delicate items to handle, but embedded in a raft they may be adequately protected and can be used to monitor the strain of the raft itself.

Pressure sensors can be based on vibrating cylinders which change their vibrational characteristics depending upon their internal pressures.

Fibre optic sensors can also be used to measure e.g. strain, temperature and pressure, and may be used in place of the sensor types discussed above.

Sensors embedded within the raft enjoy increased protection which can improve individual sensor reliability. This in turn can reduce a need for sensor redundancy and/or can improve overall sensor reliability for a given cost/weight penalty.

In addition, embedding sensors in the raft avoids a need to have dedicated sensor mounts, on the engine thereby reducing engine complexity, build time and weight.

Conveniently, in case of failure of embedded sensors, spare sensors may be embedded in the raft.

While the invention has been described in conjunction with the exemplary embodiments described above, many equivalent modifications and variations will be apparent to those skilled in the art when given this disclosure. Accordingly, the exemplary embodiments of the invention set forth above are considered to be illustrative and not limiting. Various changes to the described embodiments may be made within the scope of the invention defined by the following claims.

## Claims

1. A gas turbine engine (10) comprising an electrical harness, wherein:
at least a part of the electrical harness is formed by a rigid structure (702) having an
electrical system comprising electrical conductors embedded therein forming an electrical raft, the rigid structure further having one or more sensors (710) embedded therein such that the electrical conductors and the sensors are surrounded, and thereby fixed in position, by the rigid material of the rigid structure; and
the rigid structure is formed of rigid composite material;
wherein the electrical conductors embedded in the electrical raft comprise electrically conductive tracks in a flexible printed circuit board and at least one electrically conductive wire which is individually surrounded by an electrically insulating sleeve.

2. A gas turbine engine (10) according to claim 1, wherein the sensors are temperature sensors, fire sensors, vibration sensors, strain gauges, and/or pressure sensors.

3. A gas turbine engine (10) according to claim 2, wherein the composite material contains layers (708) of continuous reinforcing fibres, and wherein the sensors include one or more temperature sensor wires, the wires being sandwiched between neighbouring layers of continuous reinforcing fibres, and extending in directions which make angles of at least 30° with the directions of extension of most of the reinforcing fibres in the neighbouring layers.

4. A gas turbine engine (10) according to any one of the previous claims, wherein the rigid structure has an electrical system embedded therein, the sensors being electrically connected to the electrical system.

5. A gas turbine engine (10) according to any one of the previous claims, wherein the sensors are in electrical contact with the electrical conductors.

6. A gas turbine engine (10) according to claim 5, wherein the electrical conductors provide power to the sensors and/or provide signal communication with the sensors.

7. A gas turbine engine (10) according to any one of the preceding claims, further comprising a flexible cable electrically connected between the rigid structure and another component of the electrical system.

## Patentansprüche

1. Gasturbinentriebwerk (10), das einen elektrischen Kabelbaum umfasst, wobei:
zumindest ein Teil des elektrischen Kabelbaums durch eine starre Struktur (702) mit einem elektrischen System gebildet ist, das darin eingebettete elektrische Leiter umfasst, die ein elektrisches Bündel bilden, wobei die starre Struktur ferner einen oder mehrere darin eingebettete Sensoren (710) aufweist, sodass die elektrischen Leiter und die Sensoren von dem starren Material der starren Struktur umgeben und dadurch in Position fixiert sind; und
die starre Struktur aus starrem Verbundmaterial gebildet ist; wobei die in das elektrische Bündel eingebetteten elektrischen Leiter elektrisch leitfähige Bahnen in einer flexiblen Leiterplatte und mindestens einen elektrisch leitfähigen Draht umfassen, der einzeln von einer elektrisch isolierenden Hülle umgeben ist.

2. Gasturbinentriebwerk (10) nach Anspruch 1, wobei die Sensoren Temperatursensoren, Brandsensoren, Vibrationssensoren, Dehnungsmessstreifen und/oder Drucksensoren sind.

3. Gasturbinentriebwerk (10) nach Anspruch 2, wobei das Verbundmaterial Schichten (708) aus kontinuierlichen Verstärkungsfasern enthält und wobei die Sensoren einen oder mehrere Temperatursensordrähte enthalten, wobei die Drähte sandwichartig zwischen benachbarten Schichten aus kontinuierlichen Verstärkungsfasern angeordnet sind und sich in Richtungen erstrecken, die mit den Erstreckungsrichtungen der meisten Verstärkungsfasern in den benachbarten Schichten Winkel von mindestens 30° bilden.

4. Gasturbinentriebwerk (10) nach einem der vorhergehenden Ansprüche, wobei die starre Struktur ein darin eingebettetes elektrisches System aufweist, wobei die Sensoren elektrisch mit dem elektrischen System verbunden sind.

5. Gasturbinentriebwerk (10) nach einem der vorhergehenden Ansprüche, wobei die Sensoren in elektrischem Kontakt mit den elektrischen Leitern stehen.

6. Gasturbinentriebwerk (10) nach Anspruch 5, wobei die elektrischen Leiter die Sensoren mit Strom versorgen und/oder eine Signalkommunikation mit den Sensoren bereitstellen.

7. Gasturbinentriebwerk (10) nach einem der vorhergehenden Ansprüche, ferner umfassend ein flexibles Kabel, das elektrisch zwischen der starren Struktur und einer anderen Komponente des elektrischen Systems verbunden ist.

## Revendications

1. Moteur à turbine à gaz (10) comprenant un harnais électrique,
au moins une partie du harnais électrique étant formée par une structure rigide (702) possédant un système électrique comprenant des conducteurs électriques incorporés dans celle-ci formant un radeau électrique, la structure rigide possédant en outre un ou plusieurs capteurs (710) incorporés dans celle-ci de sorte que les conducteurs électriques et les capteurs soient entourés, et ainsi fixés en position, par le matériau rigide de la structure rigide ; et
ladite structure rigide étant formée de matériau composite rigide ; lesdits conducteurs électriques incorporés dans le radeau électrique comprenant des pistes électriquement conductrices dans une carte de circuit imprimé souple et au moins un fil métallique électriquement conducteur qui est entouré individuellement par un manchon électriquement isolant.

2. Moteur à turbine à gaz (10) selon la revendication 1, lesdits capteurs étant des capteurs de température, des capteurs d'incendie, des capteurs de vibration, des jauges de contrainte et/ou des capteurs de pression.

3. Moteur à turbine à gaz (10) selon la revendication 2, ledit matériau composite contenant des couches (708) de fibres de renforcement continues, et lesdits capteurs comprenant un ou plusieurs fils métalliques de capteur de température, les fils métalliques étant intercalés entre des couches voisines de fibres de renforcement continues, et s'étendant dans des directions qui font des angles d'au moins 30° avec les directions d'extension de la plupart des fibres de renforcement dans les couches voisines.

4. Moteur à turbine à gaz (10) selon l'une quelconque des revendications précédentes, ladite structure rigide possédant un système électrique incorporé dans celle-ci, les capteurs étant connectés électriquement au système électrique.

5. Moteur à turbine à gaz (10) selon l'une quelconque des revendications précédentes, lesdits capteurs étant en contact électrique avec les conducteurs électriques.

6. Moteur à turbine à gaz (10) selon la revendication 5, lesdits conducteurs électriques fournissant une puissance aux capteurs et/ou fournissant à une communication de signal les capteurs.

7. Moteur à turbine à gaz (10) selon l'une quelconque des revendications précédentes, comprenant en outre un câble souple connecté électriquement entre la structure rigide et un autre composant du système électrique.
